# EUROPEAN PATENT APPLICATION

(11) **EP 4 746 675 A1**
(43) Date of publication of application: **20.05.2026**
(21) Application number: 25198388.8
(22) Date of filing: 27.08.2025
(51) Int. Cl.: H10W 20/42, H10B 12/00, H10W 20/41, H10W 20/47

(54) **SEMICONDUCTOR DEVICE**

(30) Priority: 18.11.2024 KR 20240164567
(71) Applicant: Samsung Electronics Co., Ltd., Suwon-si, Gyeonggi-do 16677 (KR)
(72) Inventor: SHIN, Hongsik, 16677 Suwon-si (KR); SEO, Youngsik, 16677 Suwon-si (KR); YOO, Seongho, 16677 Suwon-si (KR); YOON, Serin, 16677 Suwon-si (KR); LEE, Ji-Hye, 16677 Suwon-si (KR); LEE, Hyunchul, 16677 Suwon-si (KR)
(74) Representative: Marks & Clerk LLP

(57) **Abstract**

A semiconductor device is disclosed. The semiconductor device may include a first interlayer insulating layer on a semiconductor substrate, first conductive patterns penetrating the first interlayer insulating layer, a second interlayer insulating layer on the first interlayer insulating layer, second conductive patterns provided in the second interlayer insulating layer and coupled to the first conductive patterns, and separation insulating patterns provided in the second interlayer insulating layer between the second conductive patterns. A portion of the second interlayer insulating layer may be between side surfaces of the separation insulating patterns and side surfaces of the second conductive patterns.

## Description

### BACKGROUND

The present disclosure relates to a semiconductor device and a method of fabricating the same.

Higher integration of semiconductor devices is required to satisfy consumer demands for superior performance and inexpensive prices. In the case of semiconductor devices, integration is an important factor in determining product prices. In the case of two-dimensional or planar semiconductor devices, because their integration is mainly determined by the area occupied by a unit memory cell, integration is greatly influenced by the level of a fine pattern forming technology. Thus, a variety of studies are being conducted to overcome technical limitations associated with the scale-down of the semiconductor device and to realize high-performance semiconductor devices.

### SUMMARY

One or more embodiments provide a semiconductor device, which has a simplified structure and can be fabricated by a simplified process. One or more embodiments may have a simplified structure that can be fabricated using a reduced number of photolithography and/or etching processes (e.g. for forming conductive patterns for connecting to source/drain regions of transistors (e.g. in peripheral circuitry)).

According to an aspect of an embodiment, a semiconductor device includes: a first interlayer insulating layer on a semiconductor substrate; first conductive patterns penetrating the first interlayer insulating layer; a second interlayer insulating layer on the first interlayer insulating layer; second conductive patterns provided in the second interlayer insulating layer and coupled to the first conductive patterns; and separation insulating patterns provided in the second interlayer insulating layer between the second conductive patterns. A portion of the second interlayer insulating layer is between side surfaces of the separation insulating patterns and side surfaces of the second conductive patterns.

According to another aspect of an embodiment a semiconductor device, includes: a first interlayer insulating layer on a semiconductor substrate; first conductive patterns penetrating the first interlayer insulating layer; a second interlayer insulating layer on the first interlayer insulating layer and covering a portion of the first conductive patterns; second conductive patterns in the second interlayer insulating layer and coupled to the first conductive patterns; separation insulating patterns provided between the second conductive patterns, wherein the separation insulating patterns penetrate the second interlayer insulating layer; and a capping insulating layer on top surfaces of the separation insulating patterns and top surfaces of the second conductive patterns. A second conductive pattern of the second conductive patterns includes: a contact portion which penetrates a lower portion of the second interlayer insulating layer and is in contact with a first conductive pattern of the first conductive patterns; and a pad portion in an upper portion of the second interlayer insulating layer, wherein the pad portion is wider than the contact portion. A separation insulating pattern of the separation insulating patterns has a first side surface. The pad portion of the second conductive pattern has a second side surface. A distance between the first side surface and the second side surface decreases as a distance from a bottom surface of the second interlayer insulating layer increases in an upward direction.

According to another aspect of an embodiment a semiconductor device includes: a semiconductor substrate including a first region and a second region; a device isolation layer in the semiconductor substrate and defining cell active regions in the first region and a peripheral active region in the second region; word line structures in the semiconductor substrate and extending along a first direction across the cell active regions; a bit line structure crossing the cell active regions, in the first region; buried contact patterns at opposite sides of the bit line structure and connected to the cell active regions; landing pads connected to the buried contact patterns, respectively, to cover a portion of the bit line structure; a gate structure on the peripheral active region; source/drain regions provided at opposite sides of the gate structure in the peripheral active region; a first interlayer insulating layer covering the gate structure, in the second region; first conductive patterns provided at opposite sides of the gate structure to penetrate the first interlayer insulating layer and connected to the source/drain regions; a second interlayer insulating layer on the first interlayer insulating layer in the second region and covering a portion of the first conductive patterns; second conductive patterns in the second interlayer insulating layer and coupled to the first conductive patterns; separation insulating patterns provided between the second conductive patterns, wherein the separation insulating patterns penetrate the second interlayer insulating layer; and a capping insulating layer on top surfaces of the separation insulating patterns and top surfaces of the second conductive patterns.

According to another aspect of an embodiment, a method of fabricating a semiconductor device includes: forming a first interlayer insulating layer to cover a semiconductor substrate; forming a first conductive pattern that penetrates the first interlayer insulating layer; forming a second interlayer insulating layer to cover the first conductive pattern; patterning the second interlayer insulating layer to form separation trenches; forming separation insulating patterns to fill the separation trenches; patterning upper portions of the second interlayer insulating layer to form a pad trench between the separation insulating patterns; patterning lower portions of the second interlayer insulating layer to form a contact hole which is connected to the pad trench and exposes the first conductive pattern; forming a second conductive pattern to fill the pad trench and the contact hole; and forming a capping insulating layer to cover a top surface of the second conductive pattern and top surfaces of the separation insulating patterns.

In an embodiment, the pad trench may have a width that decreases in a downward direction.

In an embodiment, the pad trench may have a second side surface, which is spaced apart from first side surfaces of the separation insulating patterns.

In an embodiment, the method of fabricating a semiconductor device may further include: forming an opening in a portion of the second interlayer insulating layer while the separation trenches are formed. The forming of the separation insulating patterns may include depositing a separation insulating layer to fill the separation trenches and conformally cover the opening; and etching the separation insulating layer to expose a top surface of the second interlayer insulating layer and form a separation insulating spacer in the opening.

In an embodiment, the method of fabricating a semiconductor device may further include: forming a device isolation layer to define cell active regions and a peripheral active region; forming a bit line structure crossing the cell active regions and a gate structure crossing the peripheral active region; forming buried contact patterns at opposite sides of the bit line structure, wherein the buried contact patterns are connected to the cell active region; and forming landing pads which are connected to the buried contact patterns, respectively, to cover a portion of the bit line structure. The landing pads may be formed while the first conductive patterns are formed.

At least some of the above and other features of the invention are set out in the claims.

### BRIEF DESCRIPTION OF DRAWINGS

The above and other aspects, features and advantages of embodiments will be more apparent from the following description, taken in conjunction with the accompanying drawings.
FIG. 1 is a plan view illustrating a semiconductor device according to an embodiment.
FIG. 2A is a sectional view, which is taken along lines A-A' and D-D' of FIG. 1 to illustrate a semiconductor device according to an embodiment.
FIG. 2B is sectional view, which is taken along lines B-B' and C-C' of FIG. 1 to illustrate a semiconductor device according to an embodiment.
FIGS. 3A and 3B are enlarged sectional views illustrating a portion P1 of FIG. 2B according to embodiments.
FIGS. 4 to 16 are sectional views, which are taken along lines A-A', B-B', and C-C' of FIG. 1 to illustrate a method of fabricating a semiconductor device according to an embodiment.

### DETAILED DESCRIPTION

Example embodiments will now be described more fully with reference to the accompanying drawings, in which example embodiments are shown. Each embodiment provided in the following description is not excluded from being associated with one or more features of another example or another embodiment also provided herein or not provided herein but consistent with the present disclosure. As used herein, the term "and/or" includes any and all combinations of one or more of the associated listed items. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Unless indicated otherwise, terms "higher" and "lower" indicate vertical alignment in relation to the drawings. For instance, "higher", "lower", "top", "bottom" and other similar terms may relate to positions defined along a direction (e.g. a vertical direction) that is perpendicular to an upper surface of a substrate. These terms need not imply any particular orientation of the device in use. Parameters that are described as being "about" a particular value may be considered to be equal to that value, or substantially equal (e.g. within manufacturing tolerance of the value, such as within 5% or 10% of the value). Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. The singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements. It will be also understood that, even if a certain operation of manufacturing an apparatus or structure is described later than another operation, the operation may be performed later than the other operation unless the other operation is described as being performed after the operation.

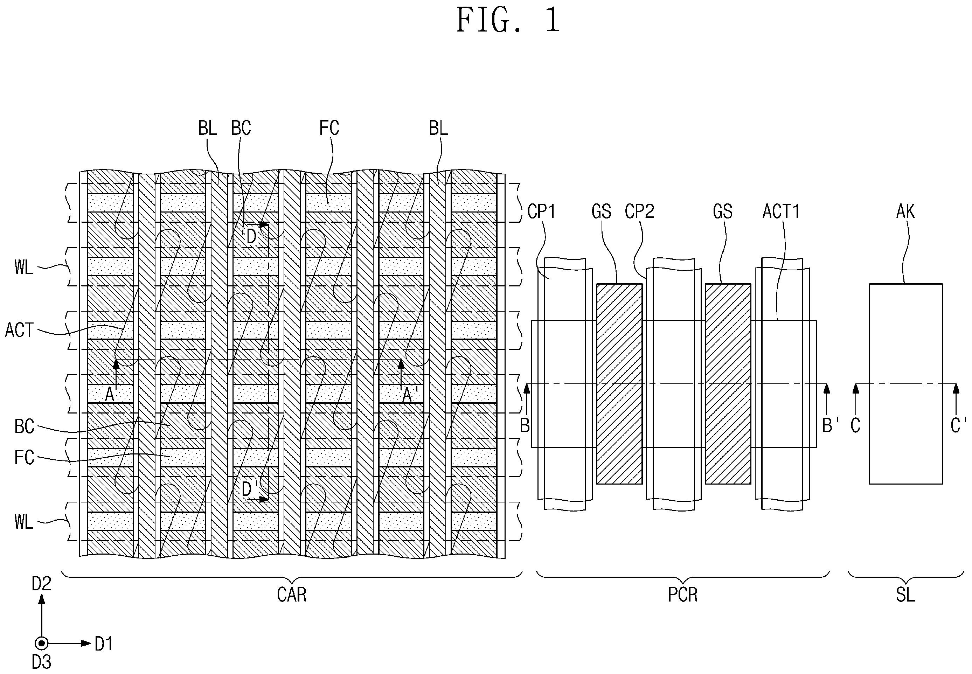

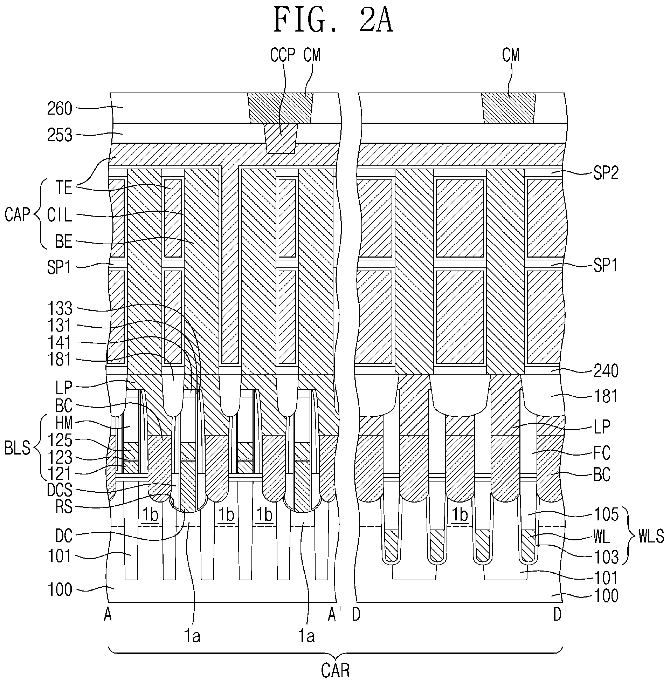

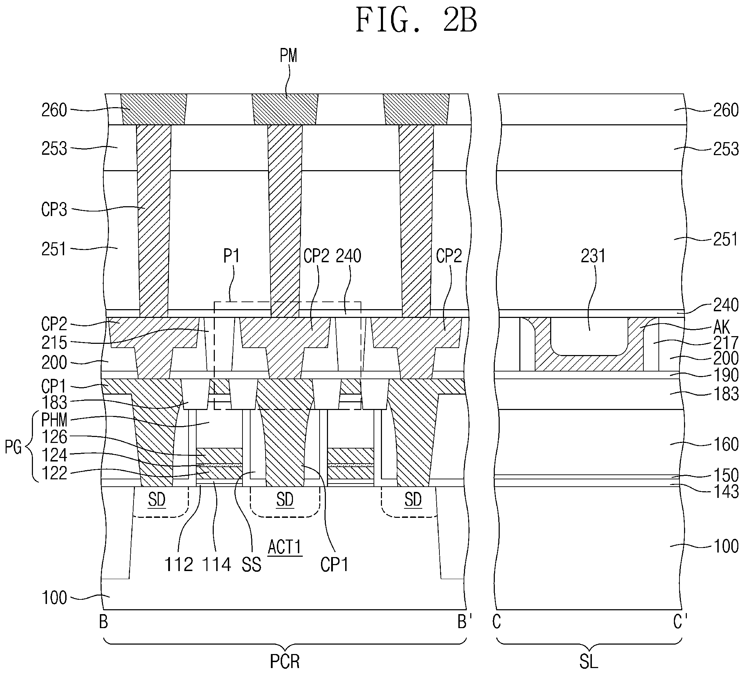

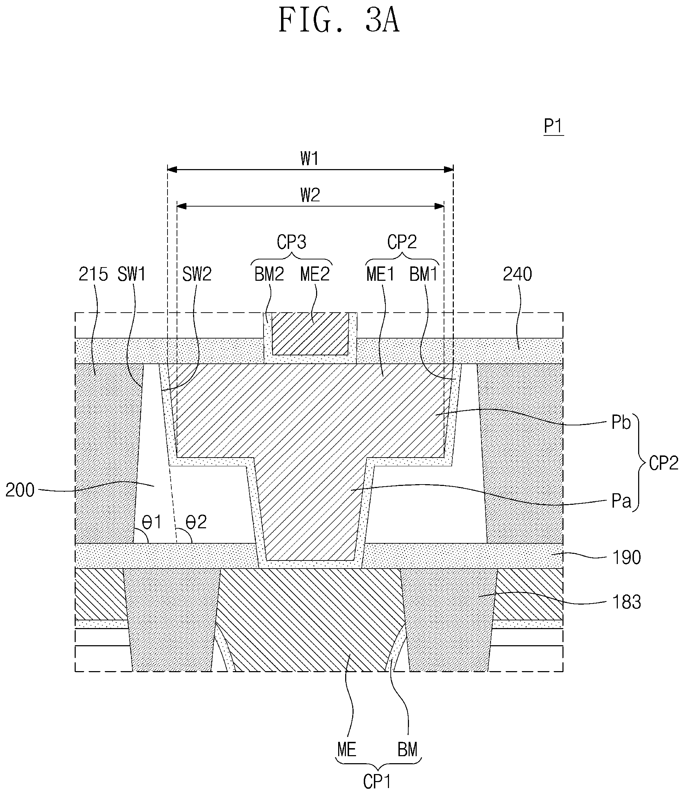

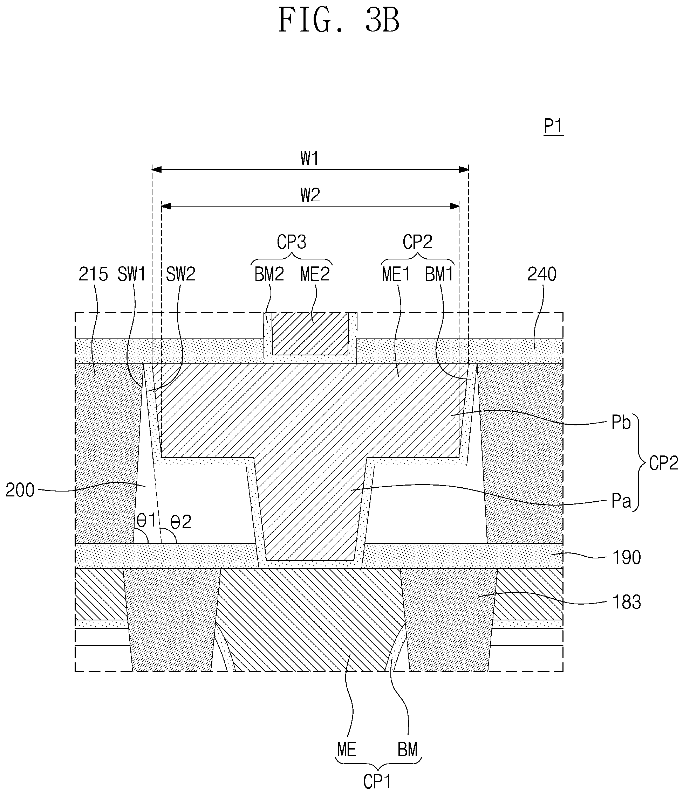

FIG. 1 is a plan view illustrating a semiconductor device according to an embodiment. FIG. 2A is a sectional view, which is taken along lines A-A' and D-D' of FIG. 1 to illustrate a semiconductor device according to an embodiment. FIG. 2B is sectional view, which is taken along lines B-B' and C-C' of FIG. 1 to illustrate a semiconductor device according to an embodiment. FIGS. 3A and 3B are enlarged sectional views illustrating a portion P1 of FIG. 2B for respective embodiments.

Referring to FIGS. 1, 2A, and 2B, a semiconductor substrate 100 may be a silicon substrate, a germanium substrate, and/or a silicon-germanium substrate. The semiconductor substrate 100 may include a first region CAR, a second region PCR, and a third region SL.

The first region CAR may be a memory cell array region, on which word lines, bit lines, and memory cells are disposed. The second region PCR may be a peripheral circuit region, on which peripheral circuits (e.g., a sense amplifier and/or a word line driver) controlling the memory cells are disposed. The third region SL may be a scribe line region or an edge region, on which monitoring patterns and/or test patterns used for a fabrication process are disposed. An overlay key, an alignment key, or a photo key may be provided on the third region SL.

A device isolation layer 101 may be disposed in the first region CAR to define cell active regions ACT in the semiconductor substrate 100. The device isolation layer 101 may be formed of or include at least one of silicon oxide, silicon nitride, or silicon oxynitride. A top surface of the device isolation layer 101 may be coplanar with a top surface of the semiconductor substrate 100.

In an embodiment, when viewed in a plan view, the cell active regions ACT may have a rectangular or bar shape and may be two-dimensionally arranged in a first direction D1 and a second direction D2, which cross each other. For example, the first direction D1 and the second direction D2 may be perpendicular to each other. The first direction D1 and the second direction D2 may be parallel to an upper surface of the substrate 100. A third direction D3 may correspond to a vertical direction that is perpendicular to each of the first and second directions D1 and D2. The third direction D3 may be perpendicular to the upper surface of the substrate. When viewed in a plan view, the cell active regions ACT may be arranged in a zigzag shape and may each have a long axis elongated in a direction diagonal to the first and second directions D1 and D2.

A plurality of word line structures WLS may be disposed in (e.g. on) the semiconductor substrate 100 and may extend in the first direction D1 to cross the cell active regions ACT and the device isolation layer 101, when viewed in a plan view. Each word line structure WLS may be disposed on the semiconductor substrate 100 (e.g. passing through active cell regions ACT in the substrate 100). Each of the cell active regions ACT may cross a pair of the word line structures WLS.

Each of the word line structures WLS may include a word line WL, a gate insulating pattern 103 between the semiconductor substrate 100 and the word line WL, and a gate capping pattern 105 on the word line WL.

Top surfaces of the word lines WL may be located at a level lower than the top surface of the semiconductor substrate 100. Heights of bottom surfaces of the word lines WL may vary depending on a material of an underlying element. As an example, portions of the bottom surfaces of the word lines WL provided on the cell active regions ACT may be placed at a height that is higher than other portions provided on the device isolation layer 101. A top surface of the gate capping pattern 105 may be substantially coplanar with the top surface of the semiconductor substrate 100 and the top surface of the device isolation layer 101.

The word lines WL may include a conductive material. The gate insulating pattern 103 may be formed of or include at least one of silicon oxide, silicon nitride, silicon oxynitride, or at least one high-k dielectric material. The gate insulating pattern 103 may have a single- or multi-layered structure. A high-k dielectric material may be a material having a dielectric constant (k) that is higher than that of silicon oxide. The high-k dielectric material may include hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

Top surfaces of the gate capping patterns 105 may be located at substantially the same level as the top surface (e.g. an upper surface) of the semiconductor substrate 100 and the top surface of the device isolation layer 101. The gate capping patterns 105 may be formed of or include an insulating material different from the device isolation layer 101. The gate capping patterns 105 may be formed of or include at least one of silicon nitride and/or silicon oxynitride.

First and second impurity regions 1a and 1b may be formed in each of the cell active regions ACT at opposite sides of the word line structures WLS. Bottom surfaces of the first and second impurity regions 1a and 1b may be located at a specific depth from the top surfaces of the cell active regions ACT. The first impurity region 1a may be disposed in a portion of each of the cell active regions ACT located between the word line structures WLS, and the second impurity regions 1b may be disposed in end portions of each of the cell active regions ACT spaced apart from the first impurity region 1a. For each active region ACT, the first impurity region 1a may be disposed in a center portion of the active region ACT and second impurity regions 1b may be disposed at end portions of the active region ACT on either side (e.g. opposite sides) of the first impurity region 1a. The first and second impurity regions 1a and 1b may be doped to have a conductivity type different from the semiconductor substrate 100.

A first buffer insulating layer 111 and a second buffer insulating layer 113 may be sequentially provided on the semiconductor substrate 100. As an example, the first buffer insulating layer 111 may be a silicon oxide layer, and the second buffer insulating layer 113 may be a silicon nitride layer. Alternatively, only one of the first and second buffer insulating layers 111 and 113 may be provided. Each of the first and second buffer insulating layers 111 and 113 may be an island-shaped or isolated pattern, when viewed in a plan view. In an embodiment, the first and second buffer insulating layers 111 and 113 may be provided to cover end portions of two adjacent ones of the cell active regions ACT as well as a portion of the device isolation layer 101 therebetween.

Bit line structures BLS may be disposed on the first region CAR of the semiconductor substrate 100 and may extend in the second direction D2 to cross the word line structures WLS. The bit line structures BLS may be disposed on the first impurity regions 1a, respectively. In an embodiment, each of the bit line structures BLS may include a polysilicon pattern 121 extending in the second direction D2, a bit line 125 on the polysilicon pattern 121, and a hard mask pattern HM on the bit line 125.

The first and second buffer insulating layers 111 and 113 may be interposed between the polysilicon pattern 121 and the semiconductor substrate 100. A bit line contact pattern DC may be disposed between the bit line 125 and the first impurity regions 1a. The bit line contact pattern DC may be in contact with the first impurity regions 1a. The bit line contact patterns DC may be offset from the second impurity regions 1b. For example, the bit line contact patterns DC and the second impurity regions 1b may not overlap along the third direction D3. As described herein where two components are described to "overlap in a direction" a line may be drawn parallel to the direction that passes through at least a portion of each component.

The bit line contact pattern DC may be formed of or include polysilicon, and a silicide pattern 123 may be interposed between the bit line contact pattern DC and the bit line 125, and between the polysilicon pattern 121 and the bit line 125. The silicide pattern 123 may be formed of or include at least one of titanium silicide, cobalt silicide, or nickel silicide. The bit line 125 may be formed of or include at least one conductive metal nitride material (e.g., titanium nitride and tantalum nitride) and/or at least one metallic material (e.g., tungsten, titanium, and tantalum).

A bottom surface of the bit line contact pattern DC may be located at a level that is lower than the top surface of the semiconductor substrate 100 and is higher than the top surfaces of the word lines WL. For example, the bit line contact pattern DC may be locally disposed in a recess region RS, which is formed in the semiconductor substrate 100 to expose the first impurity regions 1a.

In the bit line structures BLS, the hard mask pattern HM may include an insulating material (e.g., silicon nitride).

A bit line contact spacer DCS may fill a remaining space of the recess region RS, which is partially filled with the bit line contact pattern DC. In an embodiment, the bit line contact spacer DCS may cover opposite side surfaces of the bit line contact pattern DC. For example, the bit line contact spacer DCS may include at least one of silicon oxide, silicon nitride, and/or silicon oxynitride. For example, the bit line contact spacer DCS may have a multi-layered structure.

In an embodiment, bit line spacers 131 and 133 may be disposed on opposite side surfaces of the bit line structures BLS. The bit line spacers 131 and 133 may extend in the second direction D2 and along the side surfaces of the bit line structures BLS. The bit line spacers 131 and 133 may be disposed between the side surfaces of the bit line structures BLS and a buried contact pattern BC. The bit line spacers 131 and 133 may be positioned on the bit line contact spacers DCS.

In the first region CAR, the buried contact patterns BC may be disposed between an adjacent pair of the bit line structures BLS. The buried contact patterns BC may be formed of or include at least one doped polysilicon and/or at least one metallic material. The buried contact patterns BC may be in direct contact with the second impurity regions 1b, respectively. The buried contact patterns BC may be respectively disposed between the word line structures WLS and between the bit line structures BLS, when viewed in a plan view.

The buried contact patterns BC may be two-dimensionally arranged to be spaced apart from each other. Top surfaces of the buried contact patterns BC may be located at a level lower than the top surfaces of the bit line structures BLS.

Bottom surfaces of the buried contact patterns BC may be located at a level that is lower than the top surface of the semiconductor substrate 100 (e.g. the top surfaces of the cell active regions ACT) and is higher than the bottom surface of the bit line contact pattern DC. The buried contact patterns BC may be electrically disconnected (e.g. insulated) from the bit line contact pattern DC by the bit line contact spacer DCS.

Fence insulating patterns FC may be disposed between the bit line structures BLS to be spaced apart from each other in the second direction D2. The fence insulating patterns FC may be disposed between the buried contact patterns BC, which are adjacent to each other in the second direction D2. The fence insulating patterns FC may be overlapped with the word lines WL, when viewed in a plan view. The fence insulating patterns FC may be formed of or include an insulating material (e.g., silicon nitride).

Landing pads LP may be disposed on the buried contact patterns BC, respectively. The landing pads LP may be electrically connected to the buried contact patterns BC, respectively.

In an embodiment, the landing pad LP may include a lower portion, which is formed to fill a space between the bit line structures BLS, and an upper portion, which extends from the lower portion to face portions of the bit line structures BLS. In this regard, the upper portion of the landing pad LP may be overlapped with a portion of the bit line structure BLS, when viewed in a plan view. Each of the upper portions of the landing pads LP may cover a top surface of the hard mask pattern HM of the bit line structure BLS and may have a larger width than the buried contact pattern BC. That is, an upper width of the landing pad LP may be larger than a distance between the bit line structures BLS or a width of the bit line structures BLS. In this case, because the upper portion of the landing pad LP extends to a region on the bit line structure BLS, the top surface of the landing pad LP may have an increased area.

The top surface of the landing pad LP may be placed at a level higher than the top surfaces of the bit line structures BLS, and the bottom surface of the landing pad LP may be placed at a level lower than the top surfaces of the bit line structures BLS.

In an embodiment, when viewed in a plan view, the upper portion of the landing pad LP may have an elliptical shape with long and short axes, and here, the long axis of the upper portion of the landing pad LP may be inclined in a direction diagonal to both of the first and second directions D1 and D2. In an embodiment, the upper portion of the landing pad LP may have a rounded diamond shape, a rounded trapezoidal shape, or a rounded tetragonal shape.

Each of the landing pads LP may include a barrier metal pattern and a metal pattern. The barrier metal pattern may be formed of or include at least one conductive metal nitride material (e.g., titanium nitride, tantalum nitride, and tungsten nitride). The metal pattern may be formed of or include at least one metallic material (e.g., tungsten, titanium, and tantalum). A metal silicide layer (e.g., titanium silicide, cobalt silicide, nickel silicide, tungsten silicide, platinum silicide, or molybdenum silicide) may be interposed between the barrier metal pattern of each landing pad LP and the buried contact pattern BC.

Pad insulating patterns 181 may fill a region between the upper portions of the landing pads LP. The pad insulating patterns 181 may have a rounded bottom surface, and the bottom surfaces of the pad insulating patterns 181 may be in contact with portions of the bit line spacers 131 and 133. Top surfaces of the pad insulating patterns 181 may be coplanar with top surfaces of the landing pads LP. The pad insulating patterns 181 may be formed of or include at least one of silicon oxide, silicon nitride, and/or silicon oxynitride. The pad insulating patterns 181 may be provided to have a single- or multi-layered structure.

Capacitors CAP, which are used as the data storing elements of the memory cells, may be disposed on the landing pads LP. In an embodiment, variable resistance patterns, which can be switched to one of two different resistance states by an electric pulse, may be provided as the data storing elements instead of the capacitors CAP. In an embodiment, the semiconductor device may be a memory device. For instance, the semiconductor device may be a random access memory (RAM) device, such as a Dynamic RAM (DRAM) device. Nevertheless, the improvements described herein with regard to improved contacts (e.g. first and second conductive patterns CP1 and CP2) may be provided in other forms of semiconductor device.

The capacitors CAP may include bottom electrodes BE, a top electrode TE, and a dielectric layer CIL interposed therebetween.

The bottom electrodes BE may be electrically connected to the second impurity regions 1b, respectively, through the landing pads LP and the buried contact patterns BC. In an embodiment, the bottom electrodes BE may be arranged to form a honeycomb shape or a zigzag shape, when viewed in a plan view.

The bottom electrodes BE may be disposed on the landing pads LP, respectively. The bottom electrodes BE may have a pillar shape or a cylinder shape. The bottom electrodes BE may be formed of or include at least one metallic material (e.g., ruthenium (Ru), titanium (Ti), tantalum (Ta), niobium (Nb), iridium (Ir), molybdenum (Mo), and/or tungsten (W)), conductive metal nitride materials (e.g., titanium nitride (TiN), tantalum nitride (TaN), niobium nitride (NbN), molybdenum nitride (MoN), and/or tungsten nitride (WN)), or conductive metal oxide materials (e.g., iridium oxide (IrO₂), ruthenium oxide (RuO₂), and/or strontium ruthenium oxide (SrRuO₃)).

Supporting patterns SP1 and SP2 may be disposed on side surfaces of the bottom electrodes BE. The supporting patterns SP1 and SP2 may be vertically spaced apart from each other (e.g. in the third direction D3). The supporting patterns SP1 and SP2 may be in contact with and connected to the side surfaces of the bottom electrodes BE. The supporting patterns SP1 and SP2 may physically support the bottom electrodes BE, and thereby prevent the bottom electrodes BE from collapsing or tilting. The supporting patterns SP1 and SP2 may be formed of or include at least one of silicon oxide, silicon nitride, and/or silicon oxynitride.

The dielectric layer CIL may be disposed on the bottom electrodes BE. The dielectric layer CIL may be provided on the side surfaces of the bottom electrodes BE and the top and bottom surfaces of the supporting patterns SP1 and SP2. The dielectric layer CIL may conformally cover the side surfaces of the bottom electrodes BE and the top and bottom surfaces of the supporting patterns SP1 and SP2. The dielectric layer CIL may have a single- or multi-layered structure. The dielectric layer CIL may be formed of or include at least one metal oxide material, at least one perovskite dielectric material, and/or combinations thereof. In an embodiment, the metal oxide materials may include HfO₂, ZrO₂, Al₂O₃, La₂O₃, Ta₂O₃, and/or TiO₂. The perovskite dielectric materials may include SrTiO₃ (STO), (Ba,Sr)TiO₃ (BST), BaTiO₃, PZT, and/or PLZT.

The top electrode TE may be provided on the dielectric layer CIL to face the bottom electrodes BE. In an embodiment, the top electrode TE may be formed of or include at least one doped semiconductor material, at least one metallic material, at least one metal nitride material, and/or at least one metal silicide material. The semiconductor material may include silicon, germanium, and/or silicon-germanium.

In an embodiment, various peripheral circuits, which are used to operate the memory cells may be provided on the second region PCR of the semiconductor substrate 100. The peripheral circuits may be electrically connected to the memory cells. In an embodiment, the peripheral circuits may include sense amplifier circuits and sub-word line driver circuits. The peripheral circuits may further include power and ground circuits for driving a sense amplifier, but embodiments are not limited thereto.

In more detail, a peripheral active region ACT1 may be defined in the second region PCR by the device isolation layer 101.

A peripheral gate structure GS may be disposed on the peripheral active region ACT1, and source/drain regions SD may be provided in the semiconductor substrate 100 at opposite sides of the peripheral gate structure GS. The source/drain regions SD may contain impurities of a first conductivity type (e.g., n-type) which are doped into the semiconductor substrate 100.

The peripheral gate structure GS may include a peripheral polysilicon pattern 122, a peripheral silicide pattern 124, a peripheral metal pattern 126, and a peripheral hard mask pattern PHM, which are sequentially stacked.

The peripheral polysilicon pattern 122 may have substantially the same thickness as the polysilicon pattern 121 in the first region CAR. The peripheral silicide pattern 124 may have substantially the same thickness as the silicide pattern 123 in the first region CAR and may include the same metallic material as the silicide pattern 123. The peripheral metal pattern 126 may have substantially the same thickness as the bit line 125 in the first region CAR and may include the same metallic material as the bit line 125.

A first gate insulating pattern 112 and a second gate insulating pattern 114 may be interposed between the peripheral polysilicon pattern 122 and the semiconductor substrate 100. The first gate insulating pattern 112 may have substantially the same thickness as the first buffer insulating layer 111 in the first region CAR and may include the same material as the first buffer insulating layer 111. The second gate insulating pattern 114 may have substantially the same thickness as the second buffer insulating layer 113 in the first region CAR and may include the same material as the second buffer insulating layer 113.

A first interlayer insulating layer 160 may cover the peripheral gate structures GS and the semiconductor substrate 100, in the second and third regions PCR and SL. The first interlayer insulating layer 160 may include an insulating material. As an example, the first interlayer insulating layer 160 may be formed of or include at least one of silicon oxide, silicon nitride, tetraethyl orthosilicate (TEOS), and at least one low-k dielectric material. A low-k dielectric material may be a material having a dielectric constant that is less than that of silicon oxide.

In the second and third regions PCR and SL, a first etch stop layer 143 may be disposed on the semiconductor substrate 100. The first etch stop layer 143 may conformally cover the peripheral gate structures GS. In the third region SL an insulating liner layer 150 may be formed on the first etch stop layer 143.

The first etch stop layer 143 may be formed of an insulating material having an etch selectivity with respect to the first interlayer insulating layer 160 and the semiconductor substrate 100. For example, the first etch stop layer 143 may be formed of or include silicon nitride and/or silicon oxynitride.

Peripheral gate spacers SS may be disposed on opposite side surfaces of the peripheral gate structures GS. The peripheral gate spacers SS may be formed of or include at least one of silicon oxide, silicon nitride, and/or silicon oxynitride.

In an embodiment, first conductive patterns CP1 may penetrate the first interlayer insulating layer 160 and the first etch stop layer 143, at opposite sides of the peripheral gate structures GS, and may be coupled to (e.g. may contact) the source/drain regions SD. Each first conductive pattern CP1 may contact a respective source/drain region SD. The first conductive patterns CP1 in the second region PCR may connect the bit line 125 in the first region CAR with the peripheral circuit. As an example, the bit line 125 in the first region CAR may be electrically connected to the source/drain regions SD in the second region PCR through the first conductive patterns CP1.

Each of the first conductive patterns CP1 may include a contact portion, which penetrates the first interlayer insulating layer 160 and is in contact with the source/drain regions SD (e.g. with a respective source/drain region SD), and a pad portion, which is disposed on the first interlayer insulating layer 160 and is connected to the contact portion. The pad portion of each first conductive pattern CP1 may have a side surface that is in direct contact with first insulating patterns 183.

Top surfaces of the first conductive patterns CP1 (i.e., top surfaces of the pad portions of the first conductive patterns CP1) may be substantially coplanar with the top surfaces of the landing pads LP in the first region CAR.

The first conductive patterns CP1 may be formed of or include at least one conductive metal nitride material (e.g., titanium nitride and tantalum nitride) and/or at least one metallic material (e.g., tungsten, titanium, and tantalum).

In detail, referring to FIGS. 3A and 3B, the first conductive patterns CP1 may include a barrier metal pattern BM and a metal pattern ME on the barrier metal pattern BM. The barrier metal pattern BM may have a substantially constant thickness. The thickness of the barrier metal pattern BM may be measured along a direction perpendicular to the surface of the metal pattern ME. The barrier metal pattern BM and the metal pattern ME may have side surfaces that are in direct contact with the first insulating patterns 183. A metal silicide pattern may be interposed between the first conductive patterns CP1 and the source/drain regions SD.

The first insulating patterns 183 may be disposed between the first conductive patterns CP1. The first insulating patterns 183 may be disposed between the pad portions of the first conductive patterns CP1. The first insulating patterns 183 may be in direct contact with side surfaces of the pad portions of the first conductive patterns CP1. Top surfaces of the first insulating patterns 183 may be substantially coplanar with the top surfaces of the first conductive patterns CP1.

The first insulating patterns 183 may cover a top surface of the first interlayer insulating layer 160, in the third region SL. In an embodiment, the first insulating patterns 183 may be formed of or include at least one of silicon oxide, silicon nitride, and/or silicon oxynitride. The first insulating patterns 183 may be provided to have a single- or multi-layered structure. The first insulating patterns 183 may include the same insulating material as the pad insulating pattern 181 of the first region CAR.

A second etch stop layer 190 may be disposed on the semiconductor substrate 100. The second etch stop layer 190 may cover a top surface of the pad insulating pattern 181 in the first region CAR, and may cover the top surfaces of the first conductive patterns CP1 in the second region PCR and may cover the top surfaces of the first insulating patterns 183 in the second and third regions PCR and SL. The second etch stop layer 190 may be formed of or include silicon nitride and/or silicon oxynitride.

In the second and third regions PCR and SL, a second interlayer insulating layer 200 may be disposed on the second etch stop layer 190. The second interlayer insulating layer 200 may include an insulating material. In an embodiment, the second interlayer insulating layer 200 may be formed of or include at least one of silicon oxide, silicon nitride, TEOS, and at least one low-k dielectric material.

Separation insulating patterns 215 may be provided to vertically penetrate the second interlayer insulating layer 200. Each of the separation insulating patterns 215 may be disposed between adjacent ones of second conductive patterns CP2. Each of the separation insulating patterns 215 may be formed of or include silicon nitride or silicon oxynitride. Each of the separation insulating patterns 215 may have a single-layered structure. Each of the separation insulating patterns 215 may have a width (e.g. in the first direction D1) that gradually decreases from its top surface to its bottom surface.

In more detail, referring to FIGS. 3A and 3B, each of the separation insulating patterns 215 may have a first side surface SW1, and the first side surface SW1 of each separation insulating pattern 215 may be inclined at an acute angle (e.g., a first angle θ1) relative to a bottom surface of the second interlayer insulating layer 200 (e.g. relative to the first direction D1). The first angle θ1 may range from about 1° to about 89°.

The second conductive patterns CP2 may be disposed in the second interlayer insulating layer 200 and in the second region PCR, and may be coupled to the first conductive patterns CP1, respectively. The second conductive patterns CP2 may be formed of or include at least one conductive metal nitride material (e.g., titanium nitride and tantalum nitride) and/or at least one metallic material (e.g., tungsten, titanium, and tantalum).

The second conductive patterns CP2 may be laterally spaced apart (e.g. in the first direction D1) from the separation insulating patterns 215. For example, a portion of the second interlayer insulating layer 200 may be disposed between the first side surfaces SW1 of the separation insulating patterns 215 and second side surfaces SW2 of the second conductive patterns CP2.

A distance between the first side surface SW1 of each separation insulating pattern 215 and the second side surface SW2 of each second conductive pattern CP2 may decrease as a distance from the bottom surface of the second interlayer insulating layer 200 increases in an upward direction (e.g. towards an upper surface of the second interlayer insulating layer 200). For example, between the second conductive patterns CP2 and the separation insulating patterns 215, the portion of the second interlayer insulating layer 200 may have a horn or wedge shape that is sharp (i.e., that comes to a point) or is truncated (i.e., has a planar upper surface).

In detail, referring to FIGS. 3A and 3B, each of the second conductive patterns CP2 may include a contact portion Pa, which penetrates the second interlayer insulating layer 200 and the second etch stop layer 190 and is in contact with one of the first conductive patterns CP1, and a pad portion Pb, which is disposed in the second interlayer insulating layer 200 and is connected to the contact portion Pa. A top surface of the pad portion Pb of each second conductive pattern CP2 may have a first width W1 (e.g. in the first direction D1), and a bottom surface of the pad portion Pb may have a second width W2 (e.g. in the first direction D1) smaller than the first width W1.

The pad portion Pb of each second conductive pattern CP2 may have the second side surface SW2. The second side surface SW2 of the second conductive pattern CP2 may be inclined at an obtuse angle (e.g., a second angle θ2) relative to the bottom surface of the second interlayer insulating layer 200. The second angle θ2 may range from about 91° to 179°.

Top surfaces of the second conductive patterns CP2 may be substantially coplanar with top surfaces of the separation insulating patterns 215.

Each of the second conductive patterns CP2 may include a first metal pattern ME1 and a first barrier metal pattern BM1, which is provided between a side surface of the first metal pattern ME1 and the second interlayer insulating layer 200 and has a substantially constant thickness.

Referring to FIG. 3A, the width of each second conductive pattern CP2 (e.g. a maximum width, such as the first width W1) may be smaller than the smallest distance between adjacent ones of the separation insulating patterns 215 (e.g. a distance measured (e.g. in the first direction D1) at the top of the separation insulating patterns 215). That is, a side surface of the first barrier metal pattern BM1 may be spaced apart from the separation insulating patterns 215. Referring to FIG. 3B, the smallest distance between adjacent ones of the separation insulating patterns 215 may be substantially equal to the width of each second conductive pattern CP2 (e.g. a maximum width, such as the first width W1). For example, at least a portion of the first barrier metal pattern BM1 of each second conductive pattern CP2 may be in contact with the separation insulating patterns 215 (e.g. at top portions or points of the second conductive patterns CP2 and separation insulating patterns 215).

A capping insulating layer 240 may cover the top surfaces of the second conductive patterns CP2 and the top surfaces of the separation insulating patterns 215 with a substantially constant thickness. The capping insulating layer 240 may be formed of or include silicon nitride and/or silicon oxynitride.

In the third region SL, the second interlayer insulating layer 200 may have an opening, and a separation insulating spacer 217 may be disposed on a side surface of the opening. The separation insulating spacer 217 may include the same insulating material as the separation insulating pattern 215.

In the third region SL, an alignment key pattern AK may be disposed in an opening provided in the separation insulating spacer 217. The alignment key pattern AK may include the same conductive material(s) as the second conductive patterns CP2.

The alignment key pattern AK may have a U-shaped section defining a recess region, and the recess region may be filled with a gapfill insulating pattern 231. The capping insulating layer 240 may cover the alignment key pattern AK and the gapfill insulating pattern 231 in the third region SL.

In the second and third regions PCR and SL, a third interlayer insulating layer 251 may be disposed on the capping insulating layer 240. The third interlayer insulating layer 251 may be provided to have a single- or multi-layered structure. The third interlayer insulating layer 251 may be formed of or include at least one of borophosphosilicate glass (BPSG), tonen silazene (TOSZ), undoped silicate glass (USG), spin-on glass (SOG), flowable oxide (FOX), TEOS, high-density plasma chemical-vapor deposition (HDP CVD) oxide, or hydrogen silisesquioxane (HSQ). A thickness of the third interlayer insulating layer 251 in the first region CAR may vary depending on the vertical lengths of the bottom electrodes BE.

A first upper insulating layer 253 may be provided on the semiconductor substrate 100. The first upper insulating layer 253 may cover the top electrode TE in the first region CAR and may cover the third interlayer insulating layer 251 in the second and third regions PCR and SL.

A cell contact plug CCP may be provided in the first region CAR to penetrate the first upper insulating layer 253 and may be coupled (e.g. connected) to the top electrode TE. In the second region PCR, third conductive patterns CP3 may penetrate the third interlayer insulating layer 251 and the first upper insulating layer 253 and may be coupled (e.g. connected) to the second conductive patterns CP2, respectively. The cell contact plug CCP and the third conductive patterns CP3 may be formed of or include at least one of tungsten (W), titanium (Ti), tantalum (Ta), and nitride materials thereof.

In the first region CAR, a cell metal line CM may be disposed on the first upper insulating layer 253 and may be connected to the cell contact plug CCP. In the second region PCR, a peripheral metal line PM may be disposed on the first upper insulating layer 253 and may be connected to the third conductive pattern CP3. A second upper insulating layer 260 may be provided on the first upper insulating layer 253 to enclose or cover the cell metal line CM and the peripheral metal line PM.

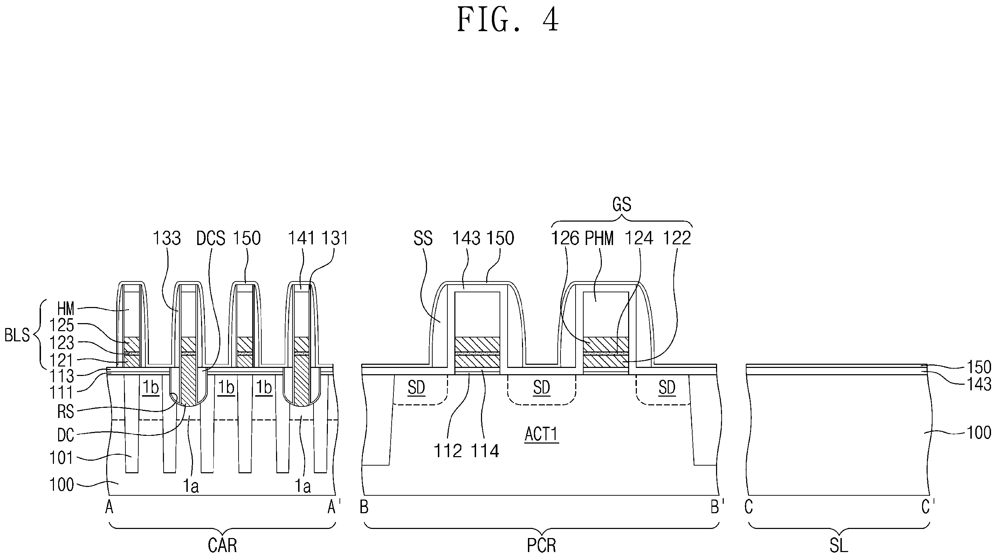

FIGS. 4 to 16 are sectional views, which are taken along lines A-A', B-B', and C-C' of FIG. 1 to illustrate a method of fabricating a semiconductor device according to an embodiment.

Referring to FIGS. 1 and 4, the semiconductor substrate 100 may be a silicon substrate, a germanium substrate, and/or a silicon-germanium substrate. The semiconductor substrate 100 may include the first region CAR, the second region PCR, and the third region SL. As described above, the first region CAR may be a memory cell array region, and the second region PCR may be a peripheral circuit region. The third region SL may be a scribe line region or an edge region, on which monitoring patterns and/or test patterns used for a fabrication process are disposed.

The device isolation layer 101 may be formed in the first and second regions CAR and PCR of the semiconductor substrate 100 to define the cell active regions ACT and peripheral active regions ACT1.

The formation of the device isolation layer 101 may include forming an etch mask on the semiconductor substrate 100, etching the semiconductor substrate 100 using the etch mask to form a trench, forming an insulating layer to fill the trench, and planarizing the insulating layer to expose the top surface of the semiconductor substrate 100. The device isolation layer 101 may include an insulating material. The device isolation layer 101 may be formed of or include at least one of silicon oxide, silicon nitride, or silicon oxynitride. The semiconductor substrate 100 may be formed of or include at least one of silicon or germanium.

In an embodiment, the cell active regions ACT may have a rectangular or bar shape and may be two-dimensionally arranged in the first and second directions D1 and D2. When viewed in a plan view, the cell active regions ACT may be arranged in a zigzag shape and may have a long axis elongated in a direction diagonal to the first and second directions D1 and D2.

In the first region CAR, a plurality of word line structures (e.g., WLS of FIG. 2A) may be formed in the semiconductor substrate 100 to extend in the first direction D1.

In detail, gate recess regions extending in the first direction D1 may be formed by patterning the cell active regions ACT and the device isolation layer 101, the gate insulating pattern 103 and the word lines WL (e.g., of FIG. 2A) may be sequentially formed in the gate recess regions. The gate capping patterns 105 (e.g., of FIG. 2A) may be formed in the gate recess regions provided with the word lines WL.

After the formation of the word line structures WLS, the first and second impurity regions 1a and 1b may be formed in the cell active regions ACT at opposite sides of the word line structures WLS. The first and second impurity regions 1a and 1b may be formed by performing an ion implantation process and may have a conductivity type different from that of the cell active regions ACT. The first impurity region 1a may be formed in a center portion of each cell active region ACT, and the second impurity regions 1b may be formed at opposite end portions of each cell active region ACT.

Next, referring to FIGS. 1 and 4, the bit line contact pattern DC and the bit line structures BLS may be formed on the first region CAR of the semiconductor substrate 100, and the peripheral gate structures GS may be formed on the second region PCR of the semiconductor substrate 100.

The first and second buffer insulating layers 111 and 113 may be sequentially formed on the semiconductor substrate 100. The first and second buffer insulating layers 111 and 113 may be formed by an oxidation process, a nitridation process, and/or a deposition process.

The first buffer insulating layer 111 may cover the top surface of the device isolation layer 101 and the top surface of the semiconductor substrate 100. The first and second buffer insulating layers 111 and 113 may include, for example, a silicon oxide layer, a silicon nitride layer, and/or a silicon oxynitride layer. As an example, the first buffer insulating layer 111 may be a silicon oxide layer, and the second buffer insulating layer 113 may be a silicon nitride layer. Alternatively, one of the first and second buffer insulating layers 111 and 113 may be omitted. The second buffer insulating layer 113 may be thicker than the first buffer insulating layer 111.

Next, the semiconductor substrate 100 and the first and second buffer insulating layers 111 and 113 may be patterned to form recess regions RS exposing the first impurity regions 1a. When an anisotropic etching process is performed to form the recess regions RS, the device isolation layer 101 and the gate capping patterns 105 (e.g., as shown in FIG. 2A), which are adjacent to the first impurity regions 1a, may be partially etched.

The bit line structures BLS may be formed in the first region CAR, and the peripheral gate structures GS may be formed in the second region PCR.

The formation of the bit line structures BLS and the peripheral gate structures GS may include forming a conductive layer on the second buffer insulating layer 113 to fill the recess regions RS, forming a second conductive layer on the conductive layer, forming a hard mask layer on the second conductive layer, forming a bit line mask pattern on the hard mask layer, and sequentially etching the conductive layer, the second conductive layer, and the hard mask layer using the bit line mask pattern and a peripheral mask pattern. Next, the bit line mask pattern and the peripheral mask pattern may be removed. Here, the conductive layer may be a doped semiconductor layer (e.g., a doped poly-silicon layer), and the second conductive layer may be a metal layer (e.g., a tungsten layer, an aluminum layer, a titanium layer, or a tantalum layer). Furthermore, a metal silicide layer may be formed between the conductive layer and the second conductive layer.

As a result of the afore-described process, the bit line structures BLS may extend in the second direction D2, on the second buffer insulating layer 113 having the recess regions RS. The bit line structures BLS may include the polysilicon pattern 121, the silicide pattern 123, the bit line 125, and the hard mask pattern HM, which are sequentially stacked. Here, a portion of the polysilicon pattern 121 may be locally formed in the recess regions RS to form the bit line contact pattern DC in direct contact with the first impurity region 1a. Side surfaces of the polysilicon pattern 121 may be spaced apart from side surfaces of the recess regions RS.

The peripheral gate structures GS may include the peripheral insulating patterns 112 and 114, the peripheral polysilicon pattern 122, the peripheral silicide pattern 124, the peripheral metal pattern 126, and the peripheral hard mask pattern PHM, which are sequentially stacked.

After the formation of the peripheral gate structures GS, peripheral source/drain regions SD may be formed by injecting dopants into portions of the peripheral active region ACT1 at opposite sides of the peripheral gate structures GS.

The first etch stop layer 143 may be formed to conformally cover the peripheral gate structures GS. The first etch stop layer 143 may be formed before the formation of the bit line structures BLS and the peripheral source/drain regions SD. In an embodiment, the first etch stop layer 143 may be formed by depositing a silicon nitride layer.

Thereafter, the bit line spacers 131 and 133 may be formed on the side surfaces of the bit line structures BLS.

The formation of the bit line spacers 131 and 133 may include sequentially depositing first and second spacer layers to conformally cover the bit line structures BLS, and sequentially and anisotropically etching the first and second spacer layers. The first and second spacer layers may also be formed in the second and third regions PCR and SL and may conformally cover the peripheral gate structures GS in the second region PCR. Here, the second spacer layer may include an insulating material having an etch selectivity with respect to the first spacer layer. As an example, the first spacer layer may be a silicon oxide layer, and the second spacer layer may be a silicon nitride layer. The first spacer layer may be used as an etch stop layer, when the second spacer layer is anisotropically etched, and the second buffer insulating layer 113 may be used as an etch stop layer, when the first spacer layer is anisotropically etched.

The bit line spacers 131 and 133 may extend along opposite side surfaces of the bit line structures BLS and in the second direction D2. In an embodiment, portions of the bit line spacers 131 and 133 may be formed to fill the recess regions RS. During the formation of the bit line spacers 131 and 133, the peripheral gate spacers SS may be formed on the side surfaces of the peripheral gate structures GS.

After the formation of the bit line spacers 131 and 133 and the peripheral gate spacers SS, an insulating liner layer 150 may be formed on the semiconductor substrate 100. The insulating liner layer 150 may be formed of or include silicon nitride and/or silicon oxynitride.

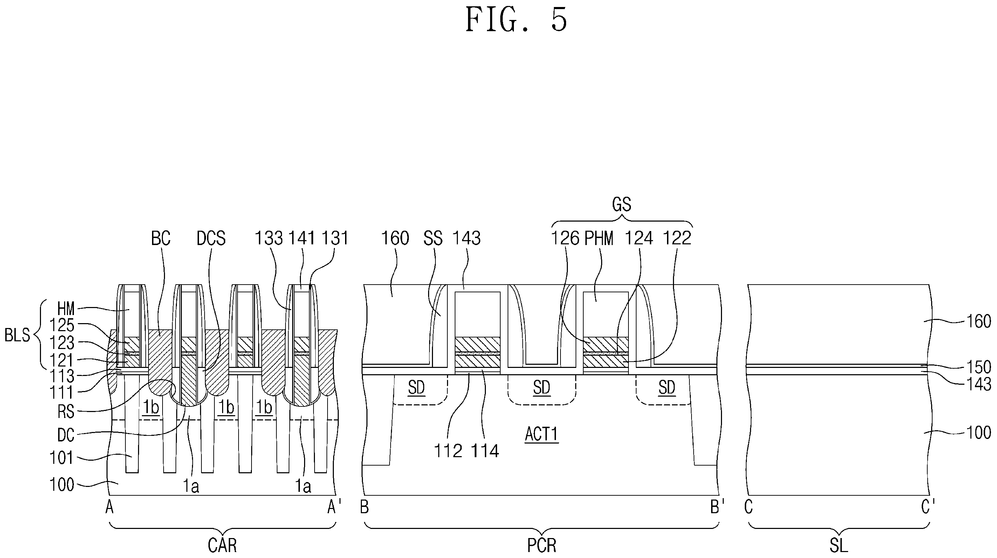

Referring to FIGS. 1 and 5, the first interlayer insulating layer 160 may be formed on the semiconductor substrate 100 to expose the first region CAR and cover the second and third regions PCR and SL.

The formation of the first interlayer insulating layer 160 may include forming an insulating layer to cover the semiconductor substrate 100 and performing a planarization process to expose the first etch stop layer 143 on the peripheral gate structure GS. The first interlayer insulating layer 160 may be formed of or include at least one of BPSG, TOSZ, USG, SOG, FOX, TEOS, HDP CVD oxide, or HSQ.

The buried contact patterns BC, which are connected to the second impurity regions 1b, may be formed in the first region CAR. The fence insulating patterns FC (e.g., of FIG. 2A) may be formed between the buried contact patterns BC, which are adjacent to each other in the second direction D2, in the first region CAR.

In more detail, the first interlayer insulating layer 160 may be removed from the first region CAR, and an anisotropic etching process may be performed on the first and second buffer insulating layers 111 and 113 using the bit line spacers 131 and 133 and the bit line structures BLS as an etch mask. Because the first and second buffer insulating layers 111 and 113 are anisotropically etched, line-shaped gap regions extending in the second direction D2 may be formed between the bit line structures BLS. Top surfaces of the second impurity region 1b may be exposed through the line-shaped gap regions.

A contact conductive layer may be formed in the line-shaped gap regions. The contact conductive layer may be in direct contact with the second impurity region 1b. In an embodiment, the contact conductive layer may be formed of or include at least one doped semiconductor material (e.g., doped silicon), at least one metallic material (e.g., tungsten, aluminum, titanium, and/or tantalum), at least one conductive metal nitride material (e.g., titanium nitride, tantalum nitride, and/or tungsten nitride), and/or at least one metal-semiconductor compound material (e.g., metal silicide).

In an embodiment, the contact conductive layer may include depositing a doped poly-silicon layer and performing a planarization process to expose the top surfaces of the bit line structures BLS. The contact conductive layer may be formed to fill the line-shaped gap region. Next, mask patterns, which are extended in the first direction D1, may be formed on the bit line structures BLS and the contact conductive layer. The mask patterns may be disposed between the word line structures WLS.

Buried contact holes which expose the gate capping patterns 105 (e.g., of FIG. 2A) may be formed by anisotropically etching the contact conductive layer using the mask patterns as an etch mask. The buried contact patterns BC may be formed in the buried contact holes. The buried contact patterns BC may be spaced apart from each other in the second direction D2, between the bit line structures BLS. In an embodiment, the bit line structures BLS and the bit line spacers 131 and 133 may be partially etched, during the anisotropic etching process on the contact conductive layer.

The fence insulating patterns FC may be formed, before and after the formation of the buried contact patterns BC. The formation of the fence insulating patterns FC (e.g., of FIG. 2A) may include forming a fence insulating layer between the bit line structures BLS to fill a line-shaped gap region extending in the second direction D2, forming mask patterns, which are extended in the first direction D1, on the fence insulating layer, and anisotropically etching the fence insulating layer using the mask patterns as an etch mask to expose the second impurity region 1b in the cell active region ACT. The fence insulating patterns FC (e.g., of FIG. 2A) may be formed of or include an insulating material (e.g., silicon nitride).

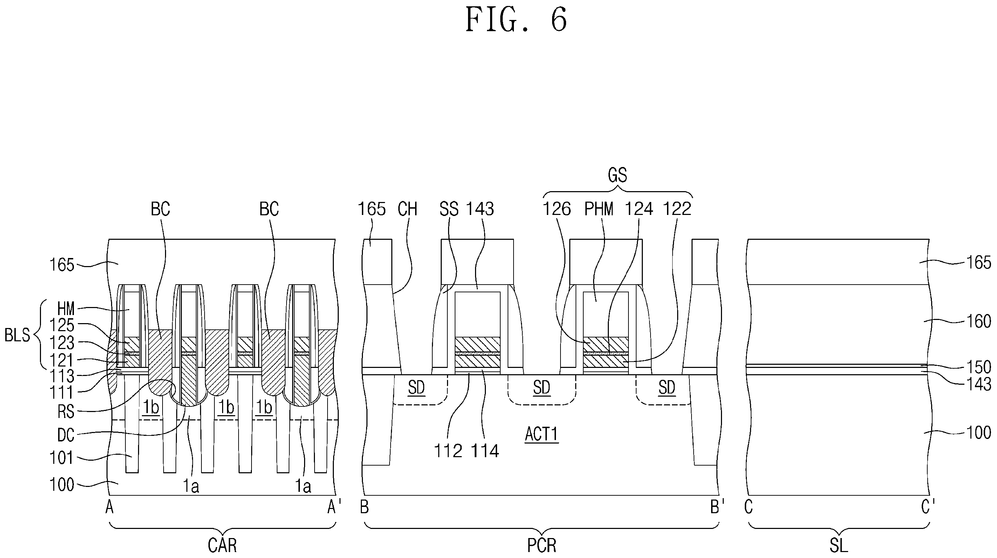

Referring to FIGS. 1 and 6, a first mask pattern 165 may be formed on the semiconductor substrate 100, after the formation of the buried contact patterns BC.

In an embodiment, the first mask pattern 165 may be formed of an amorphous carbon layer (ACL) or a spin-on-hard (SOH) mask material (e.g., SOH silicon oxide).

The first mask pattern 165 may fill regions between upper portions of the bit line structures BLS, in the first region CAR, and may be formed on the top surface of the first interlayer insulating layer 160, in the second and third regions PCR and SL. The first mask pattern 165 may have openings, which are formed on the second region PCR and correspond to the peripheral source/drain regions SD.

Thereafter, by using the first mask pattern 165 as an etch mask, contact holes CH may be formed to penetrate the first interlayer insulating layer 160 in the second region PCR and expose the peripheral source/drain regions SD.

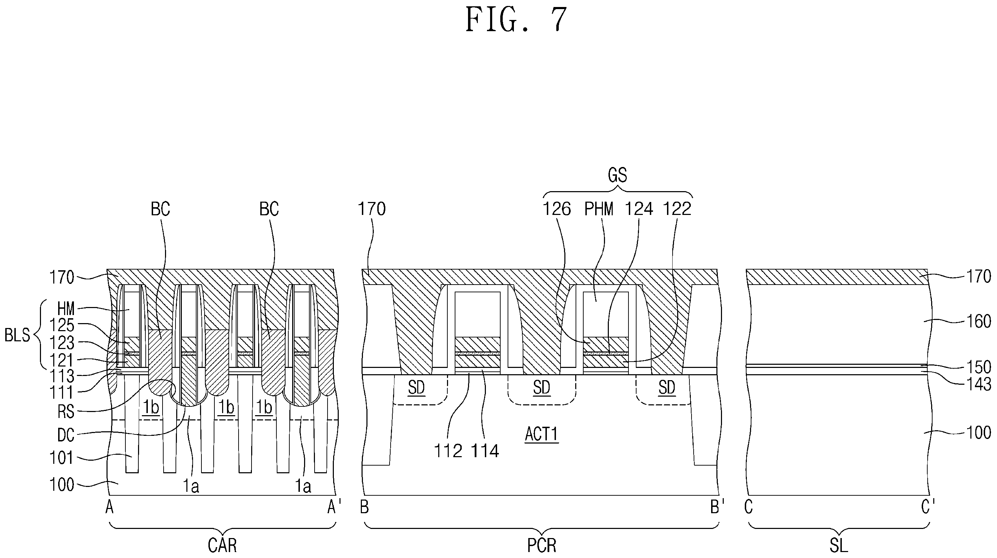

Referring to FIGS. 1 and 7, the first mask pattern 165 may be removed and a first conductive layer 170 may be deposited on the semiconductor substrate 100.

The formation of the first conductive layer 170 may include depositing a barrier metal layer to conformally cover the buried contact patterns BC and the bit line spacers 131 and 133 in the first region CAR and the contact holes CH in the second region PCR, and depositing a metal layer on the barrier metal layer to fill the contact holes CH.

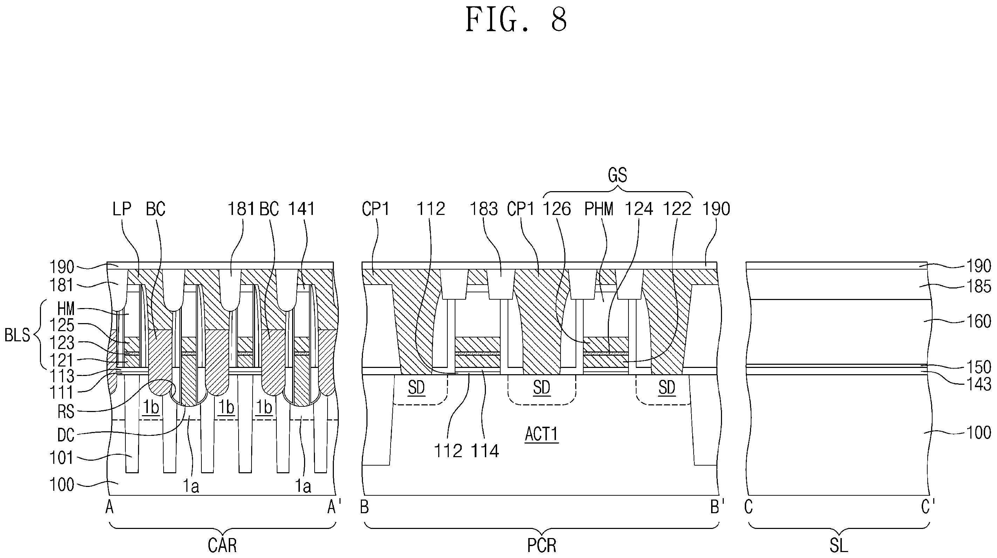

Referring to FIGS. 1 and 8, the first conductive layer 170 may be patterned to form the landing pads LP in the first region CAR, and to form the first conductive patterns CP1 in the second region PCR. The landing pads LP may be formed on the buried contact patterns BC, respectively, and the first conductive patterns CP1 may be connected to the peripheral source/drain regions SD, respectively.

The formation of the landing pads LP and the first conductive patterns CP1 may include forming mask patterns on the first conductive layer 170, and etching portions of the first conductive layer 170 using the mask patterns as an etch mask to form pad recess regions in the first region CAR and form separation recess regions in the second region PCR.

When the pad recess regions are formed in the first region CAR, the pad recess regions may have bottom surfaces, which are placed at a level lower than the top surfaces of the bit line structures BLS, and thus, the landing pads LP may be spaced apart from each other. Furthermore, the bit line spacers 131 and 133 may be partially etched, during the formation of the pad recess regions.

In the second region PCR, the separation recess regions may extend in the second direction D2 to form the first conductive patterns CP1, which are spaced apart from each other in the first direction D1. The separation recess regions may be formed to expose portions of the peripheral gate structures GS.

Next, an insulating layer may be deposited to fill the pad recess regions and the separation recess regions, and a planarization process may be performed on the insulating layer to expose top surfaces of the landing pads LP and the first conductive patterns CP1. Thus, the pad insulating patterns 181, which are formed of an insulating material, may be formed in the pad recess regions, and the first insulating patterns 183 may be formed in the separation recess regions. The first insulating patterns 183 may be in direct contact with the side surfaces of the pad portions of the first conductive patterns CP1.

Thereafter, the second etch stop layer 190 may be deposited on the semiconductor substrate 100 with a constant thickness. The second etch stop layer 190 may cover top surfaces of the pad insulating patterns 181, the landing pads LP, the first conductive patterns CP1, and the first insulating patterns 183. The second etch stop layer 190 may be formed of or include an insulating material (e.g., silicon nitride).

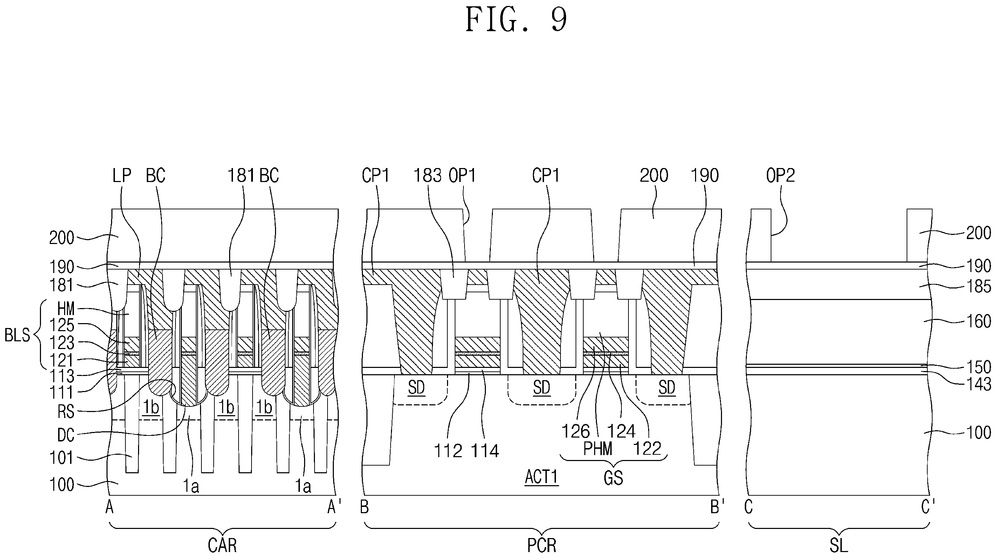

Referring to FIG. 9, the second interlayer insulating layer 200 may be formed on the second etch stop layer 190. In an embodiment, the second interlayer insulating layer 200 may be formed of or include at least one of BPSG, TOSZ, USG, SOG, FOX, TEOS, HDP CVD oxide, or HSQ.

The second interlayer insulating layer 200 may be patterned to form first openings OP1 in the second region PCR and a second opening OP2 in the third region SL. The formation of the first and second openings OP1 and OP2 may include forming a mask pattern on the second interlayer insulating layer 200 and anisotropically etching the second interlayer insulating layer 200 to expose the second etch stop layer 190. In the second region PCR, each of the first openings OP1 may have a width, which decreases in a downward direction, and may have an inclined side surface.

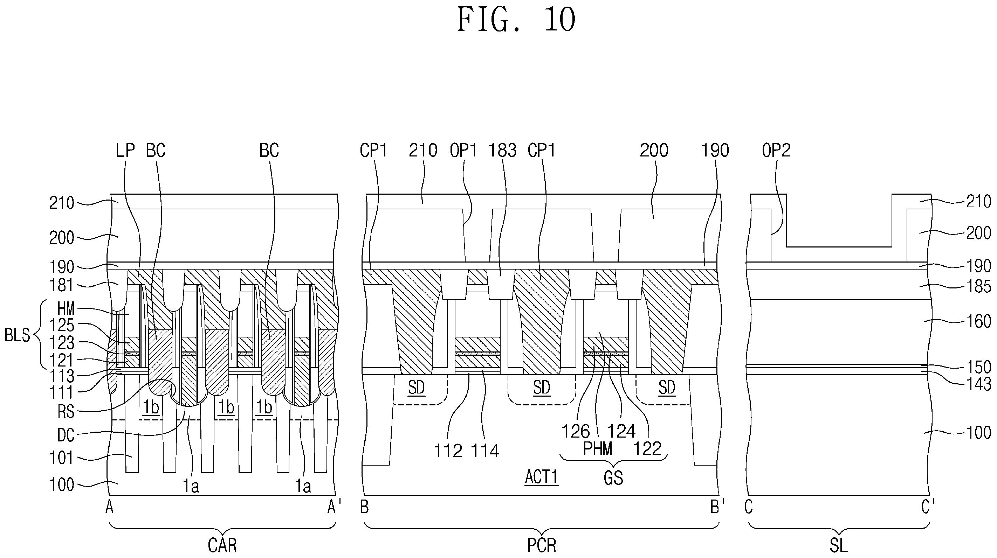

Next, referring to FIG. 10, an insulating gapfill layer 210 may be formed to fill the first openings OP1. The insulating gapfill layer 210 may be formed of or include an insulating material different from the second interlayer insulating layer 200. For example, the insulating gapfill layer 210 may be formed of or include silicon nitride or silicon oxynitride. The insulating gapfill layer 210 may be formed of a single insulating material.

The insulating gapfill layer 210 may be deposited to have a thickness that is larger than about 1/2 times the width of the first openings OP1. In the third region SL, the insulating gapfill layer 210 may cover an inner surface of the second opening OP2 with a constant or uniform thickness.

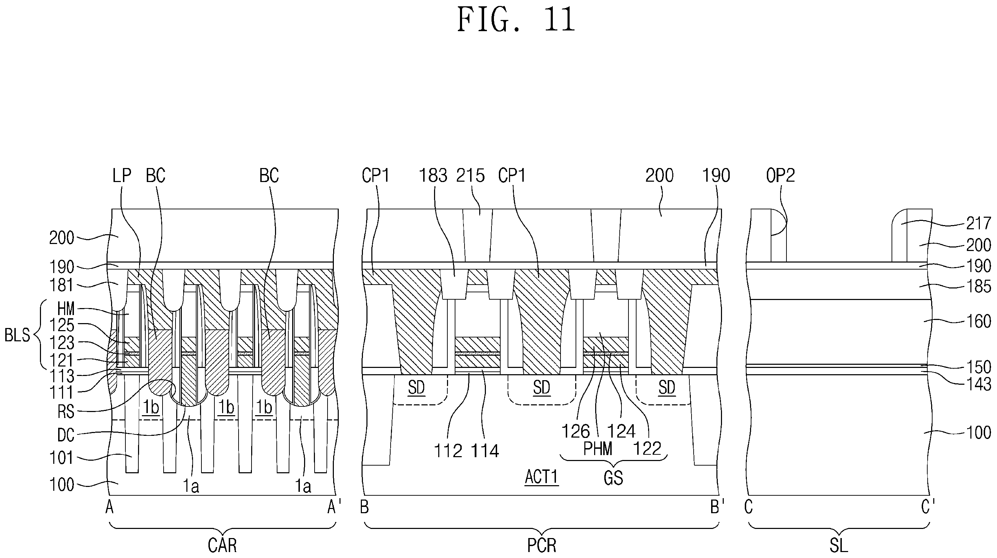

Referring to FIG. 11, an etch-back or planarization process may be performed on a top surface of the second interlayer insulating layer 200. Thus, the separation insulating patterns 215 may be formed in the first openings OP1, and the separation insulating spacer 217 may be formed on a side surface in the second opening OP2.

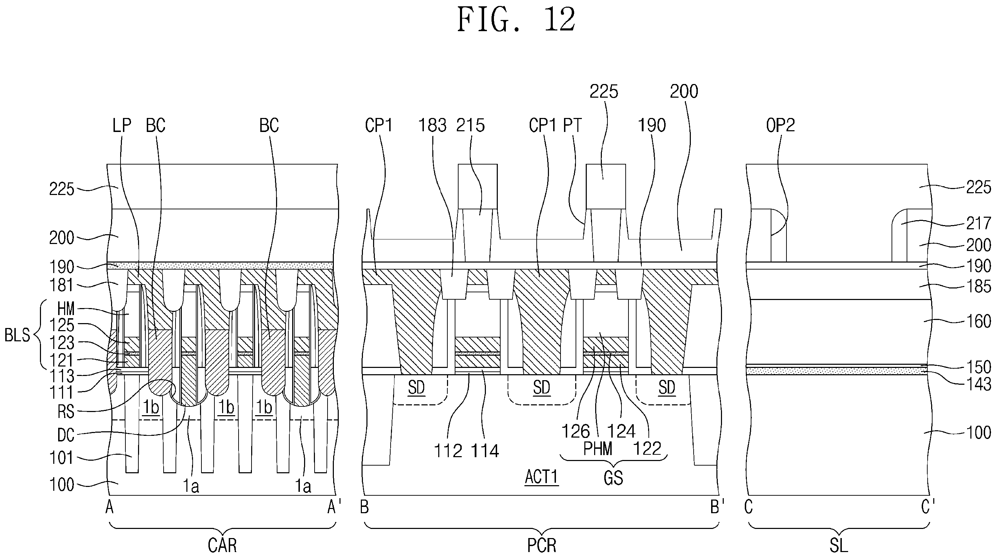

Referring to FIG. 12, after the formation of the separation insulating patterns 215 in the second region PCR, a second mask pattern 225 may be formed on the second interlayer insulating layer 200. The second mask pattern 225 may cover the first and third regions CAR and SL, and expose portions of the second interlayer insulating layer 200 in the second region PCR.

Upper portions of the second interlayer insulating layer 200 may be anisotropically etched using the second mask pattern 225 as an etch mask. Thus, pad trenches PT may be formed in the second region PCR. An etching depth of the pad trenches PT may be smaller than about 1/2 times a thickness of the second interlayer insulating layer 200. As a result of the anisotropic etching process, the pad trenches PT may have an inclined side surface. Side surfaces of the pad trenches PT may be spaced apart from the separation insulating patterns 215.

The second mask pattern 225 may be removed to expose the second interlayer insulating layer 200, after the formation of the pad trenches PT.

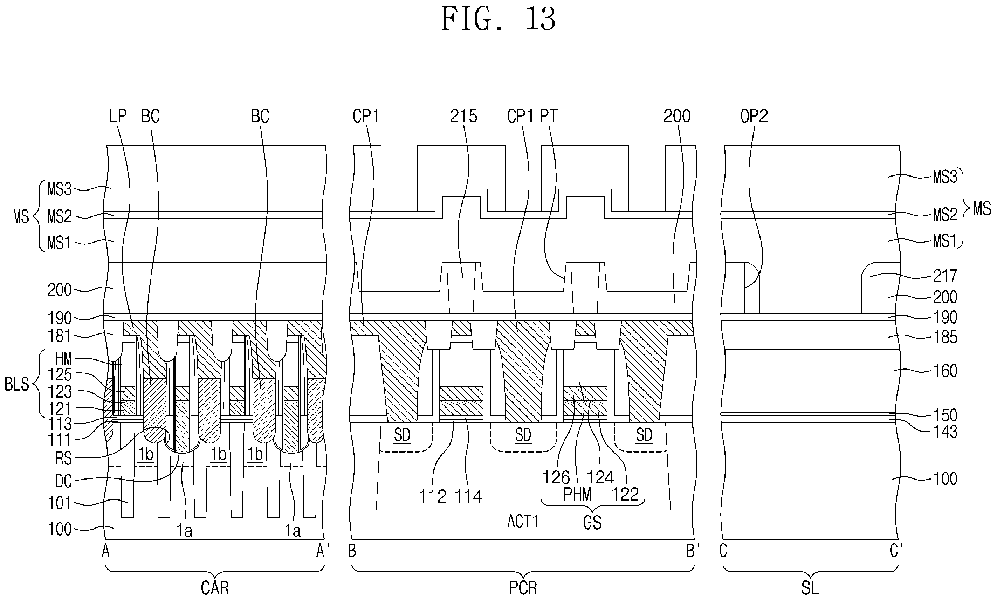

Referring to FIG. 13, a mask structure MS may be formed on the second interlayer insulating layer 200 with the pad trenches PT.

The mask structure MS may include a first mask layer MS1 on the second interlayer insulating layer 200, a second mask layer MS2 on the first mask layer MS1, and a third mask pattern MS3 on the second mask layer MS2.

The first mask layer MS1 may include, for example, an ACL. The second mask layer MS2 may include a material having an etch selectivity with respect to the first mask layer MS1. As an example, the second mask layer MS2 may be formed of or include silicon (Si) or oxynitride (SiON). The third mask pattern MS3 may be a photoresist pattern. The formation of the third mask pattern MS3 may include forming a photoresist layer on the second mask layer MS2 and performing an exposure process and a developing process on the photoresist layer.

Thereafter, the second mask layer MS2 and the first mask layer MS1 may be sequentially etched using the third mask pattern MS3 as an etch mask, and thus, a bottom surface of the pad trench PT may be exposed.

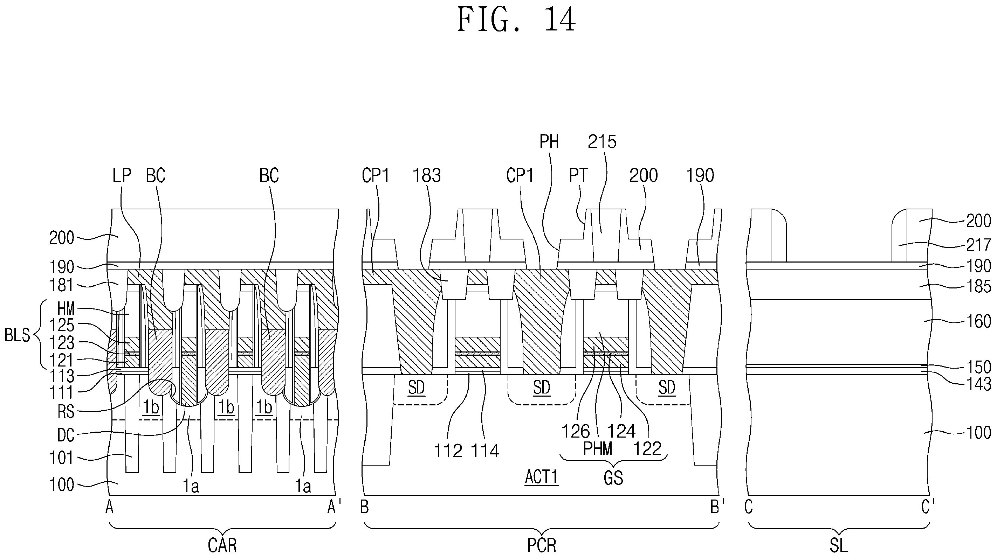

Next, referring to FIG. 14, pad contact holes PH may be formed in a lower portion of the second interlayer insulating layer 200 by anisotropically etching the second interlayer insulating layer 200 using the mask structure MS as an etch mask. The pad contact holes PH may penetrate the second interlayer insulating layer 200 and the second etch stop layer 190 in the second region PCR, and may expose the top surfaces of the first conductive patterns CP1.

The mask structure MS may be removed after the formation of the pad contact holes PH.

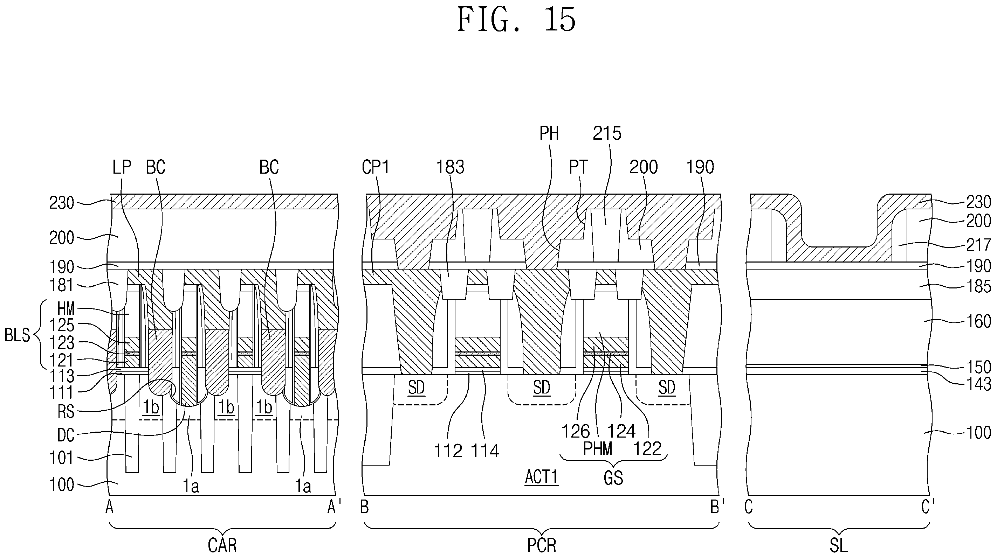

Referring to FIG. 15, a second conductive layer 230 may be deposited on the second interlayer insulating layer 200 to fill the pad contact holes PH and the pad trenches PT. In the third region SL, the second conductive layer 230 may cover the second opening OP2, in which the separation insulating spacer 217 is formed, with a constant thickness.

The formation of the second conductive layer 230 may include depositing a barrier metal layer to conformally cover the pad contact holes PH and the pad trenches PT in the second region PCR, and the top surface of the second interlayer insulating layer 200. The formation of the second conductive layer 230 may also include depositing a metal layer on the barrier metal layer to fill the pad contact holes PH and the pad trenches PT. Here, the second conductive layer 230 may be formed of a doped semiconductor layer (e.g., a doped poly-silicon layer), and the second conductive layer 230 may be formed of a metal layer (e.g., a tungsten layer, an aluminum layer, a titanium layer, or a tantalum layer).

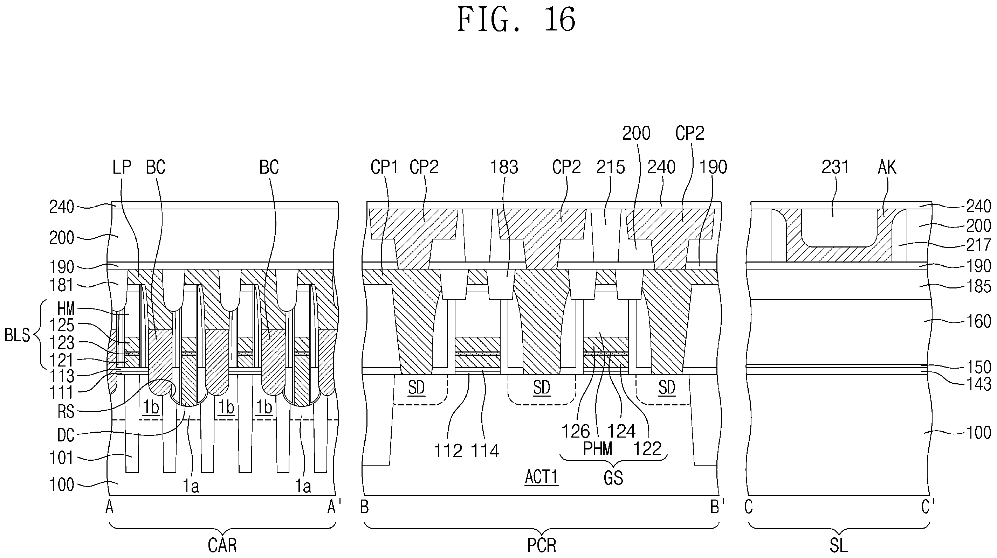

Referring to FIG. 16, an etch-back process may be performed on the second conductive layer 230 to expose the top surface of the second interlayer insulating layer 200 and the top surfaces of the separation insulating patterns 215. Thus, in the second region PCR, the second conductive patterns CP2 may be formed in the second interlayer insulating layer 200. The second conductive patterns CP2 may be connected to the first conductive patterns CP1, respectively.

In the third region SL, an insulating gapfill layer may be formed to fill the second opening OP2, before the etch-back process on the second conductive layer 230. The insulating gapfill layer in the third region SL may be planarized during the etch-back process on the second conductive layer 230, and the alignment key pattern AK may be formed in the second opening OP2 in the third region SL.

Next, the capping insulating layer 240 may be deposited on the top surface of the second interlayer insulating layer 200, the top surfaces of the second conductive patterns CP2, and the top surfaces of the separation insulating patterns 215. The capping insulating layer 240 may be deposited to have a substantially constant thickness. The capping insulating layer 240 may be formed of or include silicon nitride and/or silicon oxynitride.

Thereafter, as shown in FIGS. 2A and 2B, the capacitor CAP may be formed in the first region CAR, and the third conductive patterns CP3, which are connected to the second conductive patterns CP2, may be formed in the second region PCR.

According to an embodiment, a second conductive pattern may be coupled to a first conductive pattern connected to a peripheral circuit, and it may be possible to reduce the number of photolithography and etching processes performed when the second conductive pattern is formed. Thus, it may be possible to reduce a process difficulty and a fabrication cost in a process of fabricating a semiconductor device.

Embodiments are set out in the following Clauses:
Clause 1. A semiconductor device, comprising:
   a first interlayer insulating layer on a semiconductor substrate;
   first conductive patterns penetrating the first interlayer insulating layer;
   a second interlayer insulating layer on the first interlayer insulating layer and covering a portion of the first conductive patterns;
   second conductive patterns in the second interlayer insulating layer and coupled to the first conductive patterns;
   separation insulating patterns provided between the second conductive patterns, wherein the separation insulating patterns penetrate the second interlayer insulating layer; and
   a capping insulating layer on top surfaces of the separation insulating patterns and top surfaces of the second conductive patterns,
   wherein a second conductive pattern of the second conductive patterns comprises:
      a contact portion which penetrates a lower portion of the second interlayer insulating layer and is in contact with a first conductive pattern of the first conductive patterns; and
      a pad portion in an upper portion of the second interlayer insulating layer, wherein the pad portion is wider than the contact portion,
   wherein a separation insulating pattern of the separation insulating patterns has a first side surface,
   wherein the pad portion of the second conductive pattern has a second side surface, and
   wherein a distance between the first side surface and the second side surface decreases as a distance from a bottom surface of the second interlayer insulating layer increases in an upward direction.
Clause 2. The semiconductor device of Clause 1, wherein the pad portion of the second conductive pattern has a width that increases from its bottom surface to its top surface.
Clause 3. The semiconductor device of Clause 1 or Clause 2, further comprising:
   a device isolation layer in the semiconductor substrate and defining a cell active region and a peripheral active region;
   a bit line structure crossing the cell active region;
   a gate structure crossing the peripheral active region; and
   source/drain regions provided in the peripheral active region at opposite sides of the gate structure,
   wherein the first conductive patterns are coupled to the source/drain regions.
Clause 4. The semiconductor device of Clause 3, further comprising:
   buried contact patterns at opposite sides of the bit line structure and connected to the cell active region; and
   landing pads connected to the buried contact patterns, respectively, and provided to cover a portion of the bit line structure,
   wherein top surfaces of the first conductive patterns are coplanar with top surfaces of the landing pads.
Clause 5. A semiconductor device, comprising:
   a semiconductor substrate comprising a first region and a second region;
   a device isolation layer in the semiconductor substrate and defining cell active regions in the first region and a peripheral active region in the second region;
   word line structures in the semiconductor substrate and extending along a first direction across the cell active regions;
   a bit line structure crossing the cell active regions, in the first region;
   buried contact patterns at opposite sides of the bit line structure and connected to the cell active regions;
   landing pads connected to the buried contact patterns, respectively, to cover a portion of the bit line structure;
   a gate structure on the peripheral active region;
   source/drain regions provided at opposite sides of the gate structure in the peripheral active region;
   a first interlayer insulating layer covering the gate structure, in the second region;
   first conductive patterns provided at opposite sides of the gate structure to penetrate the first interlayer insulating layer and connected to the source/drain regions;
   a second interlayer insulating layer on the first interlayer insulating layer in the second region and covering a portion of the first conductive patterns;
   second conductive patterns in the second interlayer insulating layer and coupled to the first conductive patterns;
   separation insulating patterns provided between the second conductive patterns, wherein the separation insulating patterns penetrate the second interlayer insulating layer; and
   a capping insulating layer on top surfaces of the separation insulating patterns and top surfaces of the second conductive patterns.
Clause 6. The semiconductor device of Clause 5, wherein the top surfaces of the second conductive patterns are coplanar with the top surfaces of the separation insulating patterns.
Clause 7. The semiconductor device of Clause 5 or Clause 6, wherein the top surfaces of the second conductive patterns are farther from the semiconductor substrate than top surfaces of the landing pads.
Clause 8. The semiconductor device of any of Clauses 5-7, wherein top surfaces of the first conductive patterns are coplanar with top surfaces of the landing pads.
Clause 9. The semiconductor device of any of Clauses 5-8, wherein each of the first conductive patterns comprises:
   a contact portion which penetrates the first interlayer insulating layer and is in contact with the source/drain regions; and
   a pad portion on the first interlayer insulating layer and connected to the contact portion.
Clause 10. The semiconductor device of Clause 9, further comprising first insulating patterns between the pad portions of the first conductive patterns,
   wherein top surfaces of the first insulating patterns are coplanar with top surfaces of the first conductive patterns.
Clause 11. The semiconductor device of any of Clauses 5-10, wherein a second conductive pattern of the second conductive patterns comprises:
   a contact portion which penetrates a lower portion of the second interlayer insulating layer and is in contact with a first conductive pattern of the first conductive patterns; and
   a pad portion in an upper portion of the second interlayer insulating layer, wherein the pad portion is wider than the contact portion,
   wherein a separation insulating pattern of the separation insulating patterns has a first side surface,
   wherein the pad portion of the second conductive pattern has a second side surface, and
   wherein a distance between the first side surface and the second side surface decreases as a distance from a bottom surface of the second interlayer insulating layer increases in an upward direction.

While aspects of example embodiments have been particularly shown and described, it will be understood by one of ordinary skill in the art that variations in form and detail may be made therein without departing from the scope of the attached claims.

## Claims

1. A semiconductor device, comprising:
a first interlayer insulating layer (160) on a semiconductor substrate (100);
first conductive patterns (CP1) penetrating the first interlayer insulating layer (160);
a second interlayer insulating layer (200) on the first interlayer insulating layer (160);
second conductive patterns (CP2) provided in the second interlayer insulating layer (200) and coupled to the first conductive patterns (CP1); and
separation insulating patterns (215) provided in the second interlayer insulating layer (200) between the second conductive patterns (CP2),
wherein a portion of the second interlayer insulating layer (200) is between side surfaces of the separation insulating patterns (215) and side surfaces of the second conductive patterns (CP2).

2. The semiconductor device of claim 1, wherein each of the second conductive patterns (200) comprises:
a contact portion (Pa) which penetrates a lower portion of the second interlayer insulating layer (200) and is in contact with one of the first conductive patterns (CP1); and
a pad portion (Pb) in an upper portion of the second interlayer insulating layer (200) and connected to the contact portion (Pa),
wherein a top surface of the pad portion (Pb) has a first width (W1), and
wherein a bottom surface of the pad portion (Pb) has a second width (W2) smaller than the first width (W1).

3. The semiconductor device of claim 1 or claim 2, wherein top surfaces of the second conductive patterns (CP2) are coplanar with top surfaces of the separation insulating patterns (215).

4. The semiconductor device of any preceding claim, wherein the separation insulating patterns (215) have a single-layered structure and comprise an insulating material different from the second interlayer insulating layer (200).

5. The semiconductor device of any preceding claim, wherein each of the second conductive patterns (CP2) comprises a metal pattern (ME1) and a barrier metal pattern (BM1), wherein the barrier metal pattern (BM1) is provided between a side surface of the metal pattern (ME1) and the second interlayer insulating layer (200) and has a constant thickness.

6. The semiconductor device of any preceding claim, wherein each of the first conductive patterns (CP1) comprises:
a contact portion which penetrates the first interlayer insulating layer (160) and is in contact with source/drain regions (SD) of the semiconductor device; and
a pad portion disposed on the first interlayer insulating layer (160) and connected to the contact portion.

7. The semiconductor device of claim 6, further comprising first insulating patterns (183) between the pad portions of the first conductive patterns (CP1),
wherein top surfaces of the first insulating patterns (183) are coplanar with top surfaces of the first conductive patterns (CP1).

8. The semiconductor device of claim 7, wherein each of the first conductive patterns comprises a barrier metal pattern (BM) and a metal pattern (ME) on the barrier metal pattern (BM), and
wherein a side surface of the metal pattern (ME) is in contact with side surfaces of the first insulating patterns (183).

9. The semiconductor device of any preceding claim, further comprising:
a device isolation layer (101) in the semiconductor substrate (100) and defining an active region (ACT1);
a gate structure (GS) on the active region (ACT1); and
source/drain regions (SD) at opposite sides of the gate structure (PG),
wherein the first conductive patterns (CP1) are coupled to the source/drain regions (SD).

10. A semiconductor device, wherein:
the second interlayer insulating layer (200) covers a portion of the first conductive patterns (CP1);
the separation insulating patterns (215) penetrate the second interlayer insulating layer (200);
the semiconductor device further comprises a capping insulating layer (240) on top surfaces of the separation insulating patterns (215) and top surfaces of the second conductive patterns (CP2);
a second conductive pattern of the second conductive patterns (CP2) comprises:
a contact portion (Pa) which penetrates a lower portion of the second interlayer insulating layer (200) and is in contact with a first conductive pattern of the first conductive patterns (CP1); and
a pad portion (Pb) in an upper portion of the second interlayer insulating layer (200), wherein the pad portion (Pb) is wider than the contact portion (Pa),
a separation insulating pattern of the separation insulating patterns (215) has a first side surface;
the pad portion (Pb) of the second conductive pattern has a second side surface; and
a distance between the first side surface and the second side surface decreases as a distance from a bottom surface of the second interlayer insulating layer (200) increases in an upward direction.

11. The semiconductor device of claim 10, wherein the pad portion (Pb) of the second conductive pattern has a width that increases from its bottom surface to its top surface.

12. The semiconductor device of claim 10 or claim 11, further comprising:
a device isolation layer (101) in the semiconductor substrate (100) and defining a cell active region (ACT) and a peripheral active region (ACT1);
a bit line structure (BLS) crossing the cell active region (ACT);
a gate structure (GS) crossing the peripheral active region (ACT1); and
source/drain regions (SD) provided in the peripheral active region (ACT1) at opposite sides of the gate structure (GS),
wherein the first conductive patterns (CP1) are coupled to the source/drain regions (SD).

13. The semiconductor device of claim 12, further comprising:
buried contact patterns (BC) at opposite sides of the bit line structure (BLS) and connected to the cell active region (ACT); and
landing pads (LP) connected to the buried contact patterns (BC), respectively, and provided to cover a portion of the bit line structure (BLS),
wherein top surfaces of the first conductive patterns (CP1) are coplanar with top surfaces of the landing pads (LP).

14. A semiconductor device according to any preceding claim, further comprising:
the semiconductor substrate (100) comprising a first region (CAR) and a second region (PCR);
a device isolation layer (101) in the semiconductor substrate (100) and defining cell active regions (ACT) in the first region (CAR) and a peripheral active region (ACT1) in the second region (PCR);
word line structures (WLS) in the semiconductor substrate (100) and extending along a first direction across the cell active regions (ACT);
a bit line structure (BLS) crossing the cell active regions (ACT), in the first region (CAR);
buried contact patterns (BC) at opposite sides of the bit line structure (BLS) and connected to the cell active regions (ACT);
landing pads (LP) connected to the buried contact patterns (BC), respectively, to cover a portion of the bit line structure (BLS);
a gate structure (GS) on the peripheral active region (ACT1);
source/drain regions (SD) provided at opposite sides of the gate structure (GS) in the peripheral active region (ACT1); and
a capping insulating layer (240) on top surfaces of the separation insulating patterns (215) and top surfaces of the second conductive patterns (CP2),
wherein the first interlayer insulating layer (160) covers the gate structure (GS), in the second region (PCR),
wherein the first conductive patterns (CP1) are provided at opposite sides of the gate structure (GS) and are connected to the source/drain regions (SD),
wherein the second interlayer insulating layer (200) covers a portion of the first conductive patterns (CP1), and
wherein the separation insulating patterns (215) penetrate the second interlayer insulating layer (200).

15. The semiconductor device of claim 14, wherein the top surfaces of the second conductive patterns (CP2) are coplanar with the top surfaces of the separation insulating patterns (215).
